# EUROPÄISCHE PATENTSCHRIFT

(11) **EP 2 745 314 B1**
(45) Veröffentlichungstag und Bekanntmachung des Hinweises auf die Patenterteilung: **15.03.2017**
(21) Anmeldenummer: 11760472.8
(22) Anmeldetag: 20.09.2011
(51) Int. Cl.: H01L 21/683, H01L 21/67

(54) **VORRICHTUNG UND VERFAHREN ZUR BESCHICHTUNG EINES TRÄGERWAFERS**
DEVICE AND METHOD FOR COATING A CARRIER WAFER
PROCÉDÉ ET DISPOSITIF POUR APPLIQUER UN REVÊTEMENT SUR UNE PLAQUETTE DE SUPPORT

(43) Veröffentlichungstag der Anmeldung: 25.06.2014
(73) Patentinhaber: Ev Group E. Thallner GmbH, 4782 St. Florian am Inn (AT)
(72) Erfinder: BURGGRAF, Jürgen, A-4780 Schärding (AT)
(74) Vertreter: Schweiger, Johannes
(86) Internationale Anmeldenummer: PCT/EP2011/066345
(87) Internationale Veröffentlichungsnummer: WO 2013/041129

(56) Entgegenhaltungen:
- WO-A1-2008/142923
- JP-A- S6 240 458
- US-A- 6 033 589
- US-A1- 2007 082 134

## Beschreibung

Die vorliegende Erfindung betrifft ein Verfahren zur Beschichtung einer inneren Kreisfläche einer Beschichtungsfläche eines Trägerwafers mit einem Antihaftmaterial gemäß Patentanspruch 1.

In der Halbleitertechnologie spielen Verfahren zum temporären Bonden eine immer wichtigere Rolle, um immer dünner und großflächiger werdende Strukturwafer optimal handhaben zu können. Die Handhabung von Strukturwafern ist im Stand der Technik insbesondere dadurch verbessert worden, dass nur ein Teil des Strukturwafers an den Trägerwafer temporär gebondet wird, vorzugsweise ein Umfangsrand, Hierdurch wird eine Beaufschlagung der strukturierten Seite des Strukturwafers mit Kleber möglichst weitgehend vermieden. Dies wird im Stand der Technik dadurch gelöst, dass ausschließlich eine Randzone der Beschichtungsfläche des Trägerwafers klebend ausgebildet ist, insbesondere indem eine innere Kreisfläche des Wafers mit einem die Klebkraft verringernden Beschichtungsmaterial beschichtet wird. Bei dem nicht klebenden Beschichtungsmaterial handelt es sich mit Vorzug, aber nicht einschränkend, um ein Anti Sticking Layer Material (ASL), wie beispielsweise EasyClean Coat 1000 von der Firma 3M.

Die US 6,033,589 betrifft ein Verfahren zum Beschichten eines Wafers ohne Randwulst. Die WO 2008/142923 A1 betrifft ein Verfahren zur Aufbringung einer Membran auf der Oberfläche eines Substrats. Die US 2009/0269936 A1 betrifft eine Vorrichtung zur Aufbringung einer adhäsionsverstärkenden Substanz in einer Dampfphase auf eine Peripherie eines Substrats, um eine Adhäsionsverstärkung zu bewirken.

Der Stand der Technik weist zur Herstellung momentan folgende Schritte auf. Zuerst wird die Randzone B eines Trägerwafer mit einem Lack, beispielsweise einem Photolack beschichtet. Der Fotolack wird in einem Ofen oder auf einer Heizplatte ausgehärtet. Danach wird ein ASL vollflächig aufgebracht. Das ASL Material kann die Oberfläche des Trägerwafers, welche vom Photolack bedeckt wurde, nicht erreichen. Nach einer gewissen Einwirkungszeit, in der sich eine molekulare Schicht auf der nicht mit Photolack bedeckten zentralen Region des Trägerwafers ausgebildet hat, wird das restliche ASL Material abgeschleudert. Danach entfernt man den Photolack, beispielsweise mit Azeton. Zu diesem Zeitpunkt besteht der Trägerwafer aus zwei Zonen, einer Randzone ohne ASL Beschichtung und einer Kernzone mit ASL Beschichtung. Danach bringt man einen Kleber auf dem gesamten Trägerwafer auf. Der Kleber haftet sehr gut an der Randzone, die nicht mit ASL Material bedeckt wurde. Die Haftfestigkeit des Klebers in der Kernzone, die mit ASL Material beschichtet wurde, ist sehr gering. Der Kleber dient in dieser Kernzone vorwiegend der Unterstützung von Strukturen des, später zu dem Trägerwafer zu bondenden, Strukturwafers. Aus dem Stand der Technik ist deutlich erkennbar, dass es zur Herstellung der zwei Zonen mehrerer Schritte bedarf. Erstens, das Aufbringen des Photolacks, zweitens das Aushärten des Photolacks, drittens das Aufbringen das ASL Materials, viertens die Entfernung des Photolacks und fünftens die Aufbringung des Klebers.

Die Aufbringung der Beschichtung und des Klebers auf den Trägerwafer soll dabei möglichst kostengünstig und schnell, gleichzeitig aber in hoher Qualität, also insbesondere einer möglichst einheitlichen Schichtdicke, erfolgen.

Aufgabe der vorliegenden Erfindung ist es daher, eine Vorrichtung und ein Verfahren zur Beschichtung eines Trägerwafers derart zu optimieren, dass die Aufbringung schnell und kostengünstig, gleichzeitig aber mit hoher Qualität erfolgen kann.

Diese Aufgabe wird mit den Merkmalen des Patentanspruchs 1 gelöst. Vorteilhafte Weiterbildungen der Erfindung sind in den Unteransprüchen angegeben.

Grundidee der vorliegenden Erfindung ist es, die Beschichtung des Trägerwafers mit einem Antihaftmaterial in unterschiedlichen Zonen der Beschichtungsfläche des Trägerwafers zumindest überwiegend gleichzeitig mit der einer Hemmung, vorzugsweise Verhinderung der Beschichtung mit dem Antihaftmaterial in den Zonen (insbesondere bestehend aus einer inneren Kreisfläche und einer die innere Kreisfläche umgebenden, vorzugsweise umschließenden, äußeren Kreisringfläche) der Beschichtungsfläche vorzusehen, in welchen keine Beschichtung erfolgen soll (äußere Kreisringfläche). Das Antihaftmaterial kann insbesondere ein Antihaftmaterial sein, das ein Anhaften des Strukturwafers oder eines aufgebrachten Klebers auf dem Trägerwafer in dem Bereich möglichst weitgehend verhindert, in welchem das Antihaftmaterial auf der Beschichtungsfläche des Trägerwafers aufgebracht worden ist. Beschichtungsfläche des Trägerwafers ist meist eine Flachseite des Trägerwafers, auf der die Aufnahme des Strukturwafers mit dessen Strukturseite erfolgt, insbesondere vollflächig, vorzugsweise mit weitgehend identischer Fläche und Flächenkontur. Strukturwafer können auch Wafer mit zwei Strukturseiten sein. Da die Aufbringung des Antihaftmaterials mit Vorteil konzentrisch zum Trägerwafer erfolgt, wird das Antihaftmaterial mit Vorteil während der Rotation des Trägerwafers aufgebracht und durch die Rotation des Trägerwafers auf diesen gleichmäßig und homogen verteilt. Indem überwiegend gleichzeitig ein das Antihaftmaterial auflösendes Lösungsmittel in Bereichen des Strukturwafers aufgebracht wird, die nicht beschichtet werden sollen, insbesondere die Klebezone, wird eine Beschichtung der Beschichtungsfläche mit Antihaftmaterial in diesem Bereich zumindest weitgehend, insbesondere vollständig, vermieden. Die Beschichtung der Randzone (insbesondere äußere Kreisringfläche) kann auch dadurch verhindert werden, dass sich das Antihaftmittel über das Lösungsmittel am Rand hinwegbewegt. In einer weiteren Ausführungsform kann es sich um eine beliebige Flüssigkeit handeln, die nicht notwendigerweise ein Lösungsmittel zu sein braucht, über welche sich das Antihaftmaterial hinwegbewegen kann. Diese vorgenannten Mittel hemmen oder verhindern, insbesondere vollständig, die Beschichtung in dem Bereich, wo sie aufgebracht werden (äußere Kreisringfläche). Vorliegend werden sie daher als Beschichtungshemmmittel bezeichnet.

Nach Aushärtung des Antihaftmaterials in dem zu beschichtenden Bereich der Beschichtungsfläche und Entfernung des Beschichtungshemmmittels, insbesondere durch Rotation des Trägerwafers, oder durch Verdampfung, liegt ein Trägerwafer mit nur teilweise beschichteter Beschichtungsfläche vor, der in einem kontinuierlichen und einstufigen, erfindungsgemäßen Prozess herstellbar ist. In dem nicht beschichteten Bereich kann anschließend, insbesondere mittels der zweiten Aufbringungsmittel zur Aufbringung des Lösungsmittels, Kleber in dem nicht beschichteten Bereich der Beschichtungsfläche aufgebracht und verteilt werden. Der Kleber kann, wie im Stand der Technik bereits bekannt, auch vollflächig über das gesamte Substrat aufgebracht werden, wobei er die Bereiche mit niedriger Haftfestigkeit und hoher Haftfestigkeit gleichermaßen bedeckt. Somit ist erfindungsgemäß ein Trägerwafer mit einer mehrere Zonen aufweisenden Beschichtungsfläche zur Aufnahme eines Strukturwafers in einem erfindungsgemäßen zweistufigen Herstellungsverfahren herstellbar. Beschichtungshemmmittel und Antihaftmaterial werden mit Vorzug gleichzeitig aufgebracht. Die Einschaltsequenz sieht vor, das Lösungsmittel mit Vorzug spätestens bis zum Erreichen des Antihaftmaterial mit größerem Vorzug gleichzeitig mit dem Antihaftmaterial mit allergrößtem Vorzug vor dem Antihaftmaterial aufzubringen. Die Abschaltesequenz sieht vor, die Beschichtung mit dem Antihaftmaterial vor der Beschichtung mit dem Lösungsmittel zu beenden. Vorzugsweise findet keine wesentliche Durchmischung des Lösungsmittels mit dem Antihaftmaterial statt. In der Grenzschicht wird das Antihaftmaterial höchstens schneller durch das Lösungsmittel verdampft. Die Durchmischung der Antihaftmaterials mit dem Beschichtungshemmmittel, insbesondere Lösungsmittel, soll erfindungsgemäß so gering sein, dass die nicht zu beschichtende Zone nicht mit dem Antihaftmaterial beschichtet wird. Nach einer erfolgreichen Beschichtung der Zentralregion (insbesondere innere Kreisringfläche), kann durch jede beliebige Messmethode, mit Vorzug durch ein Kontaktwinkelmessgerät, diese Bedingung nachträglich geprüft werden. Mit Vorzug hat sich der Kontaktwinkel in der nicht zu beschichtenden nach dem erfindungsgemäßen Prozess höchstens um 15°, mit größerem Vorzug höchstens um 10°, mit noch größerem Vorzug höchstens um 5°, mit größtem Vorzug um 0° geändert.

Der bisher verwendete separate Prozessschritt der Entfernung von Material am Rand eines Wafers wird erfindungsgemäß umgewandelt in einen, insbesondere gleichzeitig mit der Beschichtung ablaufenden, Prozess der Spülung des Randes, um die Beschichtung durch ein Antihaftmaterial zu hemmen oder, vorzugsweise vollständig, zu verhindern. Die, insbesondere vollflächige, Aufbringung des Klebers ist kein zwingender Bestandteil des Verfahrens oder der Vorrichtung, kann aber in diese implementiert werden.

Gemäß einer vorteilhaften Ausführungsform ist vorgesehen, dass die ersten Aufbringmittel derart angeordnet oder anordenbar sind, dass die Aufbringung des Antihaftmaterials im Bereich der Rotationsachse R der Rotierung, insbesondere konzentrisch zum Trägerwafer, erfolgt. Hierdurch wird eine homogene Verteilung des Antihaftmaterials auf der gesamten Beschichtungsfläche ermöglicht, da die Verteilung des Antihaftmaterials insbesondere bei konstanter Rotationsgeschwindigkeit äußerst gleichmäßig entlang der Beschichtungsfläche erfolgt. Die Rotation des Trägerwafers erfolgt durch Aufnahme und Fixierung des Trägerwafers auf einer rotierbaren Aufnahme, insbesondere einem Chuck, wobei die Aufnahme und Fixierung des Trägerwafers in möglichst exakt konzentrischer Ausrichtung zur Rotationsachse der Aufnahmeeinrichtung erfolgt.

Indem die zweiten Aufbringmittel derart angeordnet oder anordenbar sind, dass die Aufbringung des Beschichtungshemmmittels zumindest an einem Umfangsabschnitt der äußeren Kreisringfläche 1a im Bereich eines radial innenliegenden Randes der äußeren Kreisringfläche erfolgt, ist auch hier das Prinzip der Verteilung des Beschichtungshemmmittels durch Rotierung des Trägerwafers anwendbar, so dass eine zumindest überwiegend gleichzeitige Aufbringung des Beschichtungshemmmittels mit dem Antihaftmaterial erfindungsgemäß denkbar ist. Lediglich der Aufbringungsort auf der Beschichtungsfläche unterscheidet sich, wobei die Aufbringung des Lösungsmittels auf den Trägerwafer weiter von der Rotationsachse R entfernt erfolgt als die Aufbringung des Antihaftmaterials Hierbei ist es von Vorteil, wenn erfindungsgemäße Steuerungsmittel zur Steuerung von einer Aufbringmenge und/oder eines Aufbringdrucks und/oder einer Aufbringgeschwindigkeit und/oder eines Aufbringwinkels und/oder eines Aufbringzeitpunkts und/oder einer Aufbringposition der ersten und/oder zweiten Aufbringmittel vorgesehen sind. Soweit die vorgenannten Parameter einstellbar ausgebildet sind, lässt sich die erfindungsgemäße Vorrichtung und das erfindungsgemäße Verfahren auf verschiedene Kombinationen von Beschichtungsmaterialien und korrespondierenden Beschichtungshemmmitteln einstellen. Bei größerer Beaufschlagung der Menge von Beschichtungshemmmitteln wird einerseits das Beschichtungsmaterial wirkungsvoller abgelöst beziehungsweise aufgelöst, beziehungsweise dass Beschichtungsmaterial wird durch das Beschichtungshemmmittel stärker daran gehindert die äußere Randzone zu bedecken beziehungsweise beschichten, andererseits wird mehr Beschichtungshemmmittel verbraucht. Durch Erhöhung des Aufbringdrucks oder der Aufbringgeschwindigkeit oder durch Wahl eines geschickten Aufbringwinkels kann der Austrag von Beschichtungshemmmittel und Beschichtungsmittel, insbesondere ohne Erhöhung der Aufbringmenge, optimiert werden.

Soweit Aushärtemittel zum Aushärten des Antihaftmaterials vorgesehen sind, wird der ein- oder zweistufige, erfindungsgemäße Prozess weiter optimiert, da das Aushärten des Antihaftmaterials insbesondere gleichzeitig mit dem Verteilen des Antihaftmaterials auf der Beschichtungsfläche erfolgen kann. In Verbindung mit ASL Materialien wird unter Aushärtung die Entstehung der monomolekularen- bzw. multimolekularen Schicht verstanden. In einer erfindungsgemäßen Ausführungsform werden solche Schichten durch Segregationseffekte an der Oberfläche gebildet. Dennoch soll unter "Aushärtung" im weiteren Verlauf des Textes, die Bildung einer nichtklebenden Schicht verstanden werden.

Gemäß einer weiteren, vorteilhaften Ausführungsform der Erfindung ist vorgesehen, dass die zweiten Aufbringmittel mindestens eine, mit einem Auslaufende zur äußeren Kreisringfläche weisend anordenbare Leitung aufweisen. Somit sind ein gerichteter Strahl und eine gezielte Aufbringung des Beschichtungshemmmittels in Bereichen der Beschichtungsfläche möglich, wo das Antihaftmaterial bei der Verteilung des Antihaftmaterials im Speziellen gelöst, oder im Allgemeinen ferngehalten werden soll, damit es dort nicht aushärtet ("Aushärtung" siehe oben).

Dabei ist es von besonderem Vorteil, wenn die zweiten Aufbringmittel, insbesondere an jedem Auslaufende, eine, insbesondere steuerbare, Düse aufweisen. Die innere Düse besitzt typischerweise einen Öffnungsdurchmesser von 0.125 Zoll, die äußere Düse typischerweise einen Öffnungsdurchmesser von 0.25 Zoll. Es sind auch Düsen mit kleineren oder größeren Öffnungsdurchmessern denkbar. Die Öffnungsdurchmesser sind größer als 0.001 Zoll, mit Vorzug größer als 0.01 Zoll, mit größerem Vorzug größer als 0.1 Zoll, insbesondere kleiner als 1 Zoll. Durch diese Maßnahme ist die erfindungsgemäße Vorrichtung nicht nur auf verschiedene Beschichtungsmaterial- und Lösungsmittel-kombinationen einstellbar, sondern auch an verschiedene Größen von Trägerwafern oder das gewünschte Verhältnis der Größe der Klebezone zur Antihaftzone einstellbar.

Soweit vorrichtungsgemäß offenbarte Merkmale auch Verfahrensmerkmale implizieren, sollen diese auch verfahrensgemäß als offenbart gelten und umgekehrt.

In den Figuren sind weitere Vorteile, Merkmale und Ausführungsformen der Erfindung offenbart. Diese zeigen in:

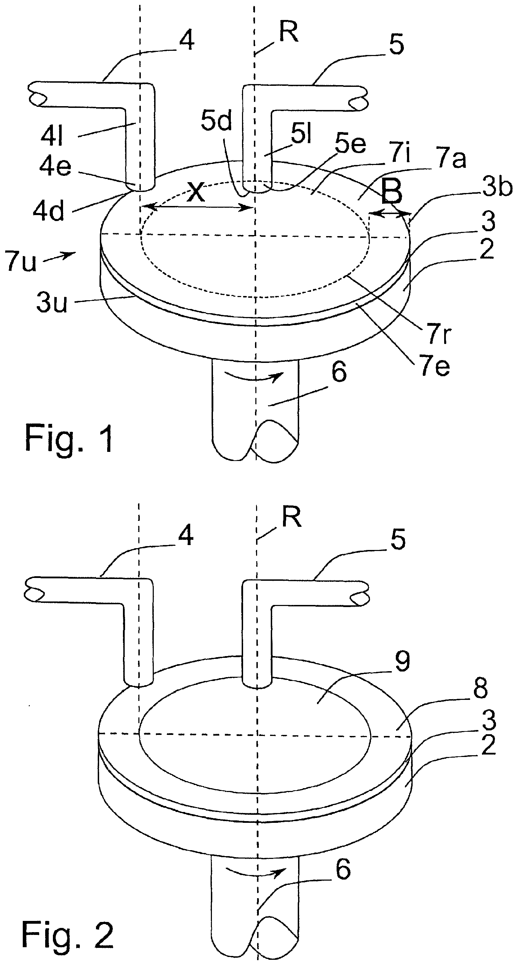

- Figur 1: eine perspektivische Ansicht einer Ausführungsform der erfindungsgemäßen Vorrichtung vor der Aufbringung von Antihaftmaterial und
- Figur 2: die Ausführungsform gemäß Figur 1 nach Durchführung des erfindungsgemäßen Zwei-Stufen-Prozesses.

In den Figuren sind gleiche oder gleichwirkende Bauteile mit den gleichen Bezugszeichen gekennzeichnet.

Die gezeigte Ausführungsform der erfindungsgemäßen Vorrichtung zur Beschichtung einer inneren Kreisfläche 7i einer Beschichtungsfläche 3b eines Trägerwafers 3 mit einem Antihaftmaterial 9 ist in den Figuren nur schematisch dargestellt und auf die für die Beschreibung der vorliegenden Erfindung wesentlichen Bestandteile reduziert. So fehlt in der Darstellung beispielsweise ein Gestell zur Halterung der gezeigten Bauteile ebenso wie eine erfindungsgemäße Steuerungseinrichtung zur Steuerung der nachfolgend beschriebenen erfindungsgemäßen Bestandteile.

Der Trägerwafer 3 wird auf eine Aufnahme 2 (beispielsweise ein Chuck) an seiner zur Beschichtungsfläche 3b abgewandten Unterseite 3u aufgenommen und fixiert, nachdem eine Ausrichtung des Trägerwafers 3 gegenüber einer Rotationsachse R erfolgt ist. Die Rotationsachse R liegt erfindungsgemäß im Mittelpunkt (Rotationssymmetriezentrum) des Trägerwafers 3. Die Rotierung erfolgt durch eine Rotierwelle 6, die durch nicht dargestellte Antriebsmittel (gesteuert durch die Steuerungseinrichtung) angetrieben wird. Die Aufnahme 2 und die Rotierwelle 6 sowie die Steuerungseinrichtung bilden gemeinsam die erfindungsgemäßen Rotiermittel.

Oberhalb der Beschichtungsfläche 3b sind erste Aufbringmittel 5 in Form einer Leitung 51 angeordnet oder anordenbar, wobei die ersten Aufbringmittel 5 zur Rotationsachse R fix oder fixierbar angeordnet sind.

In der gezeigten Ausführungsform ist die Leitung 51 an einem Auslaufende 5e mit einer Düse 5d versehen und weist in Richtung des Mittelpunkts des Trägerwafers 3 (Schnittpunkt aus Rotationsachse R und der Beschichtungsfläche 3b).

Die Leitung 51 ist an ein nicht dargestelltes Vorratsbehältnis für das Antihaftmaterial 9 angeschlossen und die Förderung des Antihaftmaterials 9 von dem Vorratsbehältnis zur Düse 5d und die Aufbringung auf die Beschichtungsfläche 3b erfolgt über eine von der Steuerungseinrichtung angesteuerte Pumpe (nicht dargestellt). Die vorgenannten Merkmale bilden die ersten Aufbringmittel 5. Das Antihaftmaterial 9 muss nicht durch eine Pumpe, sondern kann durch einen erhöhten Behälter, nur durch Einwirkung der Schwerkraft aufgebracht werden. Des Weiteren ist ein Aufbringen der Flüssigkeit mit erhöhtem Druck oder erhöhter Geschwindigkeit denkbar. Einem Fachmann auf dem Gebiet ist klar, dass es nur darauf ankommt, das Antihaftmaterial 9 aufzubringen.

Durch die ersten Aufbringmittel 5 wird das Antihaftmaterial 9 auf die innere Kreisfläche 7i, insbesondere am Schnittpunkt der inneren Kreisfläche 7i mit der Rotationsachse R (Mittelpunkt des Trägerwafers 3) aufgebracht und, insbesondere beschleunigt durch die Rotation der Rotationsmittel um die Rotationsachse R, auf der inneren Kreisfläche 7i verteilt.

Es ist leicht vorstellbar, dass durch die Rotation und die hierdurch erzeugte Zentrifugalkraft an der Beschichtungsfläche 3b das Antihaftmaterial 9 vom Mittelpunkt des Trägerwafers 3 radial und konzentrisch nach außen gefördert wird, bis es die innere Kreisfläche 7i verlässt und in eine äußere Kreisringfläche 7a eintritt. Durch die Reibung der Beschichtungsfläche 3b mit dem Antihaftmaterial 9 wird das Antihaftmaterial 9 auch in Rotationsrichtung der Rotiermittel beschleunigt, so dass das Antihaftmaterial auf einer bogenförmigen Bahn vom Mittelpunkt des Trägerwafers 3b bis zum Umfangsrand 7e beschleunigt wird. Durch die weitere Rotation wird das Antihaftmaterial 9 weiter im Wesentlichen radial nach außen zu einem Umfangsrand 7e befördert, wo das Antihaftmaterial den Trägerwafer 3 verlässt und von einer nicht dargestellten Auffangeinrichtung aufgefangen wird.

Während der Bewegung des Antihaftmaterial 9 entlang der Beschichtungsfläche 5b wird das Antihaftmaterial 9 durch Aushärtemittel ausgehärtet (Aushärtung siehe oben), so dass ohne weitere Maßnahmen eine homogene Schicht des Antihaftmaterial 9 auf der gesamten Beschichtungsfläche 3b entstehen würde. Zweite Aufbringmittel 4 zur Beaufschlagung einer die innere Kreisfläche 7i umgebenden äußeren Kreisringfläche 7a mit einem das Antihaftmaterial 9 lösbaren Lösungsmittel als Beschichtungshemmmittel sind im gezeigten Ausführungsbeispiel oberhalb des Trägerwafers 3 angeordnet beziehungsweise anordenbar. Mit Vorteil sind die Aufbringmittel beziehungsweise der Beaufschlagungsort der Beschichtungsfläche 3b der zweiten Aufbringmittel 4 durch Ausrichtungsmittel einstellbar, insbesondere durch Verstellung der Aufbringmittel 4 parallel zur Beschichtungsfläche 3b.

Die Aufbringung durch die zweiten Aufbringmittel 4 erfolgt gegenüber der Aufbringung durch die ersten Aufbringmittel 5 weiter vom Mittelpunkt des Trägerwafers 3 entfernt.

Der Aufbau der zweiten Aufbringmittel 4 kann analog der ersten Aufbringmittel 5 sein, insbesondere mit einer Leitung 41, einem Auslaufende 4e und einer Düse 4d sowie einem nicht dargestellten Vorratsbehältnis für das Lösungsmittel und einer Pumpe (gesteuert von der Steuereinrichtung).

Die Aufbringung des Lösungsmittels durch die zweiten Aufbringmittel 4 erfolgt im Bereich eines Umfangsabschnitts 7u, so dass im gezeigten Ausführungsbeispiel nur an einer Stelle am Umfang die Aufbringung des Lösungsmittels erfolgt. Erst durch die Rotation des Trägerwafers 3 durch die Rotiermittel wird jeweils nach einer Umdrehung des Trägerwafers eine äußere Kreisringfläche 7a vollständig mit dem Lösungsmittel beaufschlagt.

Die zweiten Aufbringmittel 4 sind derart angeordnet, dass das Lösungsmittel an einem innenliegenden Rand 7r der äußeren Kreisringfläche 7a, also zum Mittelpunkt des Trägerwafers 3 hin, aufgebracht wird. Von dort wird es analog dem Antihaftmaterial 9 radial nach außen und in Rotationsrichtung beschleunigt, so dass die gesamte äußere Kreisringfläche 7a kontinuierlich mit Lösungsmittel beaufschlagt wird, das das Antihaftmaterial 9 löst und/oder ein Aushärten des Antihaftmaterials 9 auf der äußeren Kreisringfläche 7a verhindert, und/oder das Antihaftmaterial 9 von der Beschichtungsfläche 3b trennt, indem es dafür sorgt, dass das Antihaftmaterial 9 über das Beschichtungshemmmittel hinweg abgeschleudert wird.

Somit verbleibt nach Aufbringung einer definierten Aufbringmenge des Antihaftmaterials 9 durch die ersten Aufbringmittel 5 ein ausgehärteter Teil des Antihaftmaterials 9 auf der inneren Kreisfläche 7i als homogene Antihaftschicht, während die Aushärtung des Antihaftmaterials 9 in der äußeren Kreisfläche 7a durch das Lösungsmittel verhindert oder zumindest gehemmt wird.

Es entsteht folglich in einem einstufigen Prozess durch gleichzeitige Aufbringung von Antihaftmaterial 9 und Beschichtungshemmmittel ein nur in der inneren Kreisfläche 7i mit Antihaftmaterial 9 (Antihaftschicht) beschichteter Trägerwafer 3.

In einem zweiten Schritt, insbesondere in der erfindungsgemäßen Vorrichtung, kann eine Klebeschicht auf die äußere Kreisringfläche 7a, insbesondere die gesamte Beschichtungsfläche 3b (also auch auf das Antihaftmaterial 9 in der inneren Kreisfläche 7i) aufgebracht werden. Hierzu können entweder die ersten und/oder zweiten Aufbringmittel 4, 5 oder gesonderte dritte Aufbringmittel (nicht dargestellt) verwendet werden.

Weiterhin können erfindungsgemäß vierte Aufbringmittel zur Reinigung des Trägerwafers 3 nach Beschichtung vorgesehen sein.

Ein Radius X der inneren Kreisfläche 7i wird definiert durch den Abstand des Aufbringungsortes des Beschichtungshemmmittels von der Rotationsachse R auf der Beschichtungsfläche 3b. Hierdurch wird automatisch auch die Ringbreite B der äußeren Kreisringfläche 7a definiert. Die Ringbreite B ist kleiner als 10 mm, mit Vorzug kleiner als 5 mm, mit noch größerem Vorzug kleiner als 2 mm, mit größtem Vorzug kleiner als 1 mm. Durch die Form der Düse 4d kann die Aufbringung des Lösungsmittels als gerichteter Strahl, insbesondere Flachstrahl, erfolgen, so dass der innenliegende Rand 7r möglichst klar abgegrenzt wird und konzentrisch zum Trägerwafer 3 verläuft.

In einer vorteilhaften Ausführungsform der Erfindung können am Umfang verteilt mehrere Leitungen 41 zur Aufbringung von Lösungsmittel an mehreren Umfangsabschnitten 7u vorgesehen sein. In einer vorteilhaften Ausführungsform kann der Aufbringwinkel (im gezeigten Ausführungsbeispiel parallel zur Rotationsachse) derart angewinkelt sein, dass die Düse 4d schräg nach außen geneigt angeordnet ist. Durch diese Maßnahme wird vermieden, dass Beschichtungshemmmittel auf die innere Kreisfläche 7i tritt.

### Bezugszeichenliste

- 2: Aufnahme
- 3: Trägerwafer
- 3b: Beschichtungsfläche
- 3u: Unterseite
- 4: zweite Aufbringmittel
- 41: Leitung
- 4d: Düse
- 4e: Auslaufende
- 5: erste Aufbringmittel
- 51: Leitung
- 5d: Düse
- 5e: Auslaufende
- 6: Rotierwelle
- 7a: äußere Kreisringfläche
- 7i: innere Kreisfläche
- 7e: Umfangsrand
- 7r: innenliegender Rand
- 7u: Umfangsabschnitt
- 8: Kleber
- 9: Antihaftmaterial
- R: Rotationsachse
- X: Radius/Abstand
- B: Ringbreite

## Patentansprüche

1. Verfahren zur Herstellung eines in einer inneren Kreisfläche (7i) mit einer Antihaftschicht (9) und in einer die innere Kreisfläche (7i) umgebenden äußeren Kreisringfläche (7a) mit Kleber beschichteten Trägerwafers (3) mit folgenden Schritten, insbesondere folgendem Ablauf:
- Aufbringung eines Antihaftmaterials (9) auf die innere Kreisfläche (7i) durch erste Aufbringmittel (5) und Verteilung des Beschichtungsmaterials (9) durch Rotierung des Trägerwafers (3) um eine Rotationsachse (R) durch Rotiermittel (2, 6),
wobei während der Verteilung des Antihaftmaterials (9) durch zweite Aufbringmittel (4) eine Aufbringung eines die Beschichtung der äußeren Kreisringfläche (7a) mit dem Antihaftmaterial (9) zumindest hemmenden Beschichtungshemmmittels auf die die innere Kreisfläche (7i) umgebende äußere Kreisringfläche (7a) erfolgt,
- wobei das Beschichtungshemmmittel vor dem Antihaftmaterial (9) auf die äußere Kreisringfläche (7a) aufgebracht wird, sodass sich das Antihaftmaterial (9) über das Beschichtungshemmmittel hinwegbewegt und die äußere Kreisringfläche (7a) nicht mit dem Antihaftmaterial (9) beschichtet wird,
- Aushärten des Antihaftmaterials (9) auf der inneren Kreisfläche (7i) zur Erzeugung der Antihaftschicht (9), wobei auf der äußeren Kreisringfläche (7a) keine Antihaftschicht (9) erzeugt wird,
- Beschichtung der äußeren Kreisringfläche (7a) mit dem Kleber.

2. Verfahren nach Anspruch 1, bei dem die Aufbringung des Antihaftmaterials (9) im Bereich der Rotationsachse (R), insbesondere konzentrisch zum Trägerwafer (1) erfolgt.

3. Verfahren nach Anspruch 1 oder 2, bei dem die Aufbringung des Lösungsmittels zumindest in einem Umfangsabschnitt (7u) der äußeren Kreisringfläche (7a) im Bereich eines radial innenliegenden Randes (7r) der äußeren Kreisringfläche (7a), insbesondere zeitversetzt zur Aufbringung des Antihaftmaterials (9) erfolgt.

4. Verfahren nach einem oder mehreren der vorhergehenden Ansprüche, bei der die Steuerungsmittel zur Steuerung von Aufbringmengen und/oder Aufbringungsdruck und/oder Aufbringungsgeschwindigkeit und/oder Aufbringungswinkeln und/oder Aufbringungszeitpunkten der ersten und/oder zweiten Aufbringmittel (4, 5) vorgesehen sind.

5. Verfahren nach einem oder mehreren der vorhergehenden Ansprüche, bei der Aushärtemittel zum Aushärten des Antihaftmaterials (9) vorgesehen sind.

6. Verfahren nach einem oder mehreren der vorhergehenden Ansprüche, bei der die zweiten Aufbringmittel (4) mindestens eine, mit einem Auslaufende (4e) zur äußeren Kreisringfläche (7a) weisend anordenbare Leitung (41) aufweisen.

7. Verfahren nach einem oder mehreren der vorhergehenden Ansprüche, bei der die zweiten Aufbringmittel (4), insbesondere an jedem Auslaufende (4e), eine, insbesondere steuerbare, Düse (4d) aufweisen.

## Claims

1. A method for producing of a carrier wafer (3) coated in an inner circular surface (7i) with an antiadhesion layer (9) and in an outer circular ring surface (7a) surrounding the inner circular surface (7i) with adhesive, with the following steps, especially the following sequence:
- application of an antiadhesive material (9) to the inner circular surface (7i) by first application means (5) and distribution of the coating material (9) by rotating the carrier wafer (3) around an axis (R) of rotation by rotating means (2, 6),
wherein during the distribution of the antiadhesive material (9) by second application means (4) the outer circular ring surface (7a) which surrounds the inner circular surface (7i) is applied with a coating inhibitor which at least inhibits the coating of the outer circular ring surface (7a),
- wherein the coating inhibitor is applied onto the outer circular ring surface (7a) prior to the antiadhesive material (9) such that the antiadhesive material (9) moves away over the coating inhibitor and the outer circular ring surface (7a) is not coated with the antiadhesive material (9),
- curing the antiadhesive material (9) on the inner circular ring surface (7i) for producing the antiadhesive layer (9), wherein on the outer circular ring surface (7a) no antiadhesive layer (9) is produced,
- coating the outer circular ring surface (7a) with the adhesive.

2. The method as claimed in Claim 1, wherein the antiadhesive material (9) is applied in the region of the axis (R) of rotation especially concentrically to the carrier wafer (1).

3. The method as claimed in Claim 1 or 2, wherein the application of the solvent at least in one peripheral section (7u) of the outer circular ring surface (7a) takes place in the region of a radially inner edge (7r) of the outer circular ring surface (7a), especially offset in time for application of the antiadhesive material (9).

4. The method as claimed in one of the preceding claims, wherein there are control means for controlling application amounts and/or application pressure and/or application speed and/or application angles and/or application instants of the first and/or second application means (4, 5).

5. The method as claimed in one of the preceding claims, wherein there are curing agents for curing of the antiadhesive material (9).

6. The method as claimed in one of the preceding claims, wherein the second application means (4) have at least one line (41) which can be arranged pointing with one outlet end (4e) toward the circular ring surface (7a).

7. The method as claimed in one of the preceding claims, wherein the second application means (4) have especially on each outlet end (4e) an especially controllable nozzle (4d).

## Revendications

1. Procédé de formation d'une tranche porteuse (3) revêtue de colle dans une surface circulaire intérieure (7i) comprenant une couche anti-adhésive (9) et dans une surface annulaire circulaire extérieure (7a) entourant la surface circulaire intérieure (7i), comprenant les étapes suivantes :
- application d'un matériau anti-adhésif (9) sur la surface circulaire intérieure (7i) par le biais de premiers moyens d'application (5) et distribution du matériau de revêtement (9) par rotation de la tranche porteuse (3) sur un axe de rotation (R) par des moyens de rotation (2, 6),
dans lequel, pendant la distribution du matériau anti-adhésif (9) par des seconds moyens d'application (4), il y a application d'un moyen d'inhibition de revêtement inhibant au moins le revêtement de la surface annulaire circulaire extérieure (7a) avec le matériau anti-adhésif (9), sur la surface annulaire circulaire extérieure (7a) entourant la surface circulaire intérieure (7i),
- dans lequel le moyen d'inhibition de revêtement est appliqué sur la surface annulaire circulaire extérieure (7a) avant le matériau anti-adhésif (9), de façon à ce que le matériau anti-adhésif (9) soit glissé au-delà du moyen d'inhibition de revêtement et que la surface annulaire circulaire extérieure (7a) ne soit pas revêtue avec le matériau anti-adhésif (9),
- durcissement par vieillissement du matériau anti-adhésif (9) sur la surface circulaire intérieure (7i) pour produire la couche anti-adhésive (9), dans lequel aucune couche anti-adhésive (9) n'est produite sur la surface annulaire circulaire extérieure (7a),
- revêtement de la surface annulaire circulaire extérieure (7a) avec la colle.

2. Procédé selon la revendication 1, dans lequel l'application du matériau anti-adhésif (9) au niveau de l'axe de rotation (R) a lieu particulièrement de façon concentrique à la tranche porteuse (1).

3. Procédé selon la revendication 1 ou 2, dans lequel l'application du solvant a lieu au moins dans un tronçon périphérique (7u) de la surface annulaire circulaire extérieure (7a) au niveau d'un bord radial intérieur (7r) de la surface annulaire circulaire extérieure (7a), en particulier décalé temporellement pour l'application de la couche anti-adhésive (9).

4. Procédé selon l'une ou plusieurs des revendications précédentes, dans lequel les moyens de commande sont prévus pour commander les quantités appliquées et/ou la pression d'application et/ou la vitesse d'application et/ou l'angle d'application et/ou les moments d'application des premier et/ou second moyens d'application (4, 5).

5. Procédé selon l'une ou plusieurs des revendications précédentes, dans lequel des moyens de durcissement par vieillissement sont prévus pour durcir le matériau anti-adhésif (9) par durcissement par vieillissement.

6. Procédé selon l'une ou plusieurs des revendications précédentes, dans lequel les seconds moyens d'application (4) présentent au moins une ligne (41) pouvant être agencée avec une extrémité de purge (4e) orientée vers la surface annulaire circulaire extérieure (7a).

7. Procédé selon l'une ou plusieurs des revendications précédentes, dans lequel les seconds moyens d'application (4) présentent, en particulier sur chaque extrémité de purge (4e), une buse (4d) pouvant en particulier être commandée.
